# FASCICULE DE BREVET EUROPEEN

(11) **EP 0 518 789 B1**
(45) Date de publication et mention de la délivrance du brevet: **11.12.1996**
(21) Numéro de dépôt: 92420194.0
(22) Date de dépôt: 09.06.1992
(51) Int. Cl.: G01R 1/04

(54) **Carte à pointes pour testeur de puces de circuit intégré**
Nadelkarte für Chiptestgeräte
Probe card for testing apparatus of chips

(30) Priorité: 11.06.1991 FR 9107477
(43) Date de publication de la demande: 16.12.1992
(73) Titulaire: SGS-THOMSON MICROELECTRONICS S.A., 94250 Gentilly (FR)
(72) Inventeur: Monnet, René, F-38170 Seyssinet-Pariset (FR); Perrin, Maurice, F-38960 Saint Etienne de Crossey (FR)
(74) Mandataire: de Beaumont, Michel

(56) Documents cités:
- EP-A- 0 288 801
- EP-A- 0 305 076
- US-A- 3 363 179
- US-A- 5 055 780

## Description

La présente invention concerne les testeurs de puces de circuits intégrés et en particulier le montage des cartes à pointes d'un tel testeur.

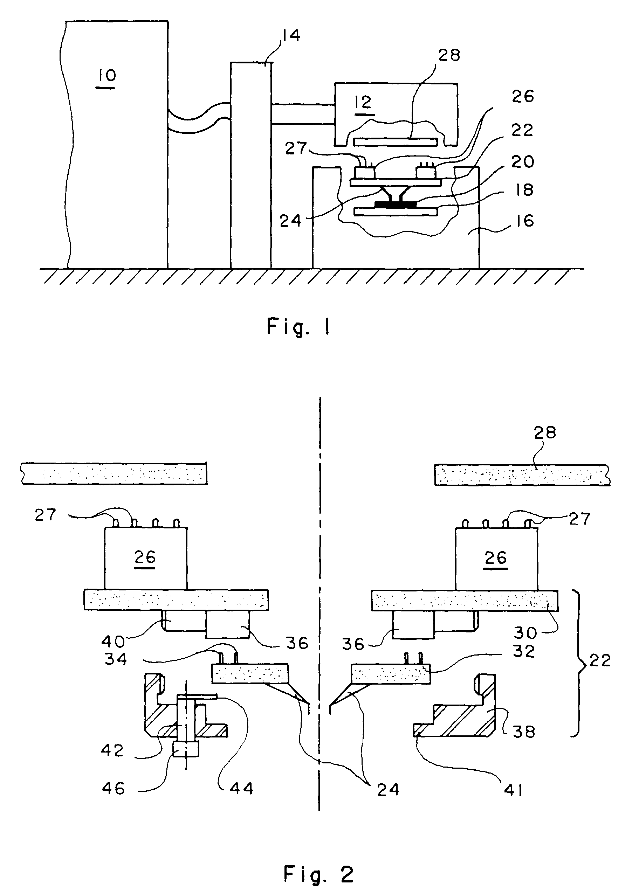

La figure 1 illustre une installation de test de plaquettes de puces de circuit intégré. Cette installation comprend un testeur 10 qui est capable de générer une multitude de signaux de test et de mesurer les réponses fournies par les puces testées à ces signaux. Le testeur 10 est relié à une tête de test 12 maintenue par un manipulateur 14 et disposée au-dessus d'un dispositif de manipulation de plaquettes 16, couramment désigné par le terme anglo-saxon "prober". Le dispositif 16 comprend un magasin de plaquettes (non représenté) et un mandrin 18 sur lequel sont disposées successivement des plaquettes 20 à tester. A la partie supérieure du dispositif, fixée au bâti, se trouve une carte à pointes 22 munie de palpeurs (pointes) 24 tournés vers le bas.

Au cours du test de la plaquette 20, le mandrin 18 se déplace de manière que les pointes 24 viennent contacter successivement les plots des puces de la plaquette 20. Ainsi, en amenant des signaux convenables jusqu'à des pointes 24 et en mesurant les tensions par l'intermédiaire d'autres pointes 24, on peut vérifier le fonctionnement des puces de la plaquette.

Actuellement, les signaux de test peuvent être des signaux de très haute fréquence (de l'ordre de 300 MHz) et on est amené à raccourcir le plus possible les connexions entre les pointes 24 et la tête de test 12 pour diminuer l'effet inductif des connexions. Pour cela, la carte à pointes 22 comprend des connecteurs 26 comportant des picots conducteurs 27 reliés aux pointes 24, dépassant sur le dessus des connecteurs et montés sur ressort. Ces picots sont destinés à contacter une carte de test 28 montée à la partie inférieure de la tête de test 12.

Une telle installation présente plusieurs inconvénients. En général, il faut une carte à pointes 22 différente par type de puce à tester. Etant donné la précision de positionnement requise, les cartes à pointes ne sont pas pratiques à monter et à démonter. De plus, pour démonter une carte à pointes, il faut ôter la tête de test 12 du dispositif 16. Si on ôte trop souvent la tête de test, les picots de contact susmentionnés peuvent se détériorer et ne plus assurer un bon contact électrique.

Un objet de la présente invention est de prévoir une carte à pointes ne devant pas être entièrement démontée lorsqu'on change le type de puce à tester.

Un autre objet de la présente invention est de prévoir une manipulation pratique d'une carte à pointes lorsqu'on change de type de puce à tester.

Ces objets sont atteints grâce à une bague maintenant une carte fille circulaire embrochée dans une carte mère et comprenant : un filetage vertical intérieur se vissant sur un filetage extérieur solidaire de la carte mère ; et un fond comportant un évidement cylindrique dans lequel est logée la carte fille, coaxial aux filetages et de profondeur sensiblement égale à l'épaisseur de la carte fille. La bague comprend dans son fond, autour de l'évidement, des axes verticaux traversants, comportant chacun à une extrémité, une partie excentrique, chaque axe pouvant être amené manuellement à une première position où sa partie excentrique obstrue partiellement l'évidement en maintenant la carte fille sans la serrer dans l'évidement, ou à une deuxième position où sa partie excentrique ne maintient pas la carte fille dans l'évidement.

Selon un mode de réalisation de la présente invention, chaque partie excentrique est en forme de coin sensiblement parallèle au fond de la bague et à faible pente.

Selon un mode de réalisation de la présente invention, le fond de la bague comprend des tétons contre lesquels viennent buter les parties excentriques à chacune des positions des axes.

Selon un mode de réalisation de la présente invention, les autres extrémités des axes sont munies de molettes.

La présente invention vise plus généralement un appareil de test d'une plaquette de puces de circuit intégré, comprenant : un dispositif de test muni à sa partie supérieure d'une carte à pointes qui palpent des plots d'une puce de la plaquette, la carte à pointes comprenant des picots montés sur ressort faisant saillie à la partie supérieure du dispositif ; et une tête de test disposée au-dessus du dispositif de test, et comprenant à sa partie inférieure une carte de test venant contacter les picots montés sur ressort. La carte à pointes comprend une carte mère dans laquelle est embrochée une carte fille maintenue avec une bague selon ce qui précède.

Ces objets, caractéristiques et avantages ainsi que d'autres de la présente invention seront exposés plus en détail dans la description suivante de modes de réalisation particuliers faite en relation avec les figures jointes parmi lesquelles :
la figure 1, précédemment décrite, représente une installation classique de test de plaquettes de puces de circuit intégré ;
la figure 2 illustre schématiquement et en coupe un mode de réalisation d'une carte à pointes selon la présente invention ;
la figure 3 illustre en demi -vue un mode de réalisation d'une bague utilisée dans la carte à pointes de la figure 2 ; et
la figure 4 illustre une vue agrandie et en coupe d'un élément de la bague de la figure 3.

A la figure 2, on retrouve plusieurs éléments de la figure 1, des mêmes éléments étant désignés par des mêmes références. La carte à pointes 22 est ici en deux parties, à savoir, une carte mère 30 et une carte fille 32. La carte mère 30 est fixée au bâti et comporte les connecteurs 26 précédemment décrits. La carte fille 32 est munie, à sa partie inférieure, des pointes 24 et à sa partie supérieure de broches 34 reliées aux pointes 24. Les broches 34 viennent s'embrocher dans des connecteurs 36 montés sur la face inférieure de la carte mère 30.

La carte fille 32 est maintenue par une bague 38 se vissant sur le filetage extérieur d'une bague 40 fixée sur la face inférieure de la carte mère 30. Le fond de la bague 38 est ouvert pour permettre le passage des pointes 24 et comprend un évidement pour loger la carte fille. La carte fille est circulaire et est maintenue par un épaulement intérieur 41 de la bague 38 appuyant sur les bords inférieurs de la carte fille.

Tel qu'on vient de le décrire, un tel système présente toutefois un inconvénient. Pour retirer une carte fille 32, il faut dévisser la bague 38 et extraire manuellement la carte fille 32 de son connecteur 36. Ceci est relativement difficile lorsque le nombre de broches 34 est important. On doit alors insérer ses ongles ou un tournevis dans les interstices entre la carte fille 32 et le connecteur 36 pour décoller la carte fille et obtenir une meilleure prise. En procédant comme cela, on peut tordre la carte fille et les positions précises des pointes 24 peuvent être faussées.

Pour éviter cet inconvénient, la bague 38 comprend selon la présente invention des dispositifs d'extraction permettant de désolidariser la carte fille 32 de la carte mère 30 en dévissant la bague 38. Autour de l'évidement recevant la carte fille 32, sont disposés plusieurs axes verticaux 42, par exemple trois à 120°, traversant la bague et comportant chacun à leur partie supérieure une partie excentrique 44 pouvant être amenée par rotation de l'axe 42 dans l'interstice entre la carte fille 32 et le connecteur 36. Les axes 42 peuvent être manipulés grâce à des molettes 46 fixées aux parties inférieures des axes. L'épaulement 41 et les parties excentriques 44 sont disposés de telle manière que la carte fille ait du jeu vertical. Ainsi, la rotation de la bague 38 n'est pas gênée. Pour extraire la carte fille, on tourne les molettes 46 pour amener les parties excentriques 44 dans l'interstice entre la carte fille et le connecteur 36 et on dévisse normalement la bague 38.

Ce système est si pratique que l'on peut envisager de laisser la tête de test 12 (figure 1) en place sur le dispositif 16 et retirer et monter les cartes fille par dessous.

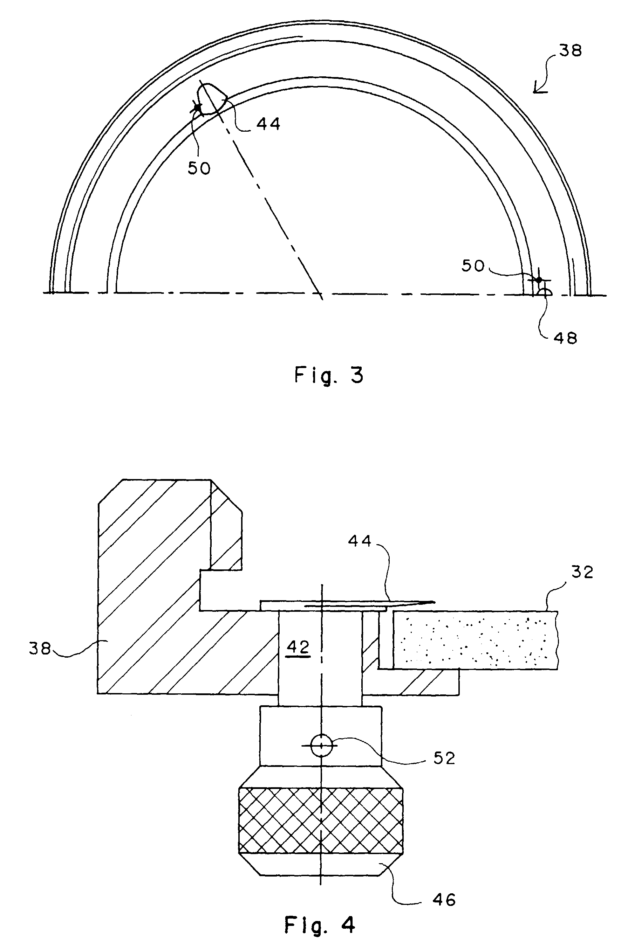

La figure 3 illustre, en vue de dessus, un mode de réalisation d'une bague d'extraction selon la présente invention. On y a représenté une partie excentrique 44 en position d'extraction et, à 120°, un trou 48 destiné à recevoir un axe 42. La partie excentrique 44, comme cela est représenté, est en forme de secteur de disque. Sa position d'extraction est repérée par un téton vertical 50, par exemple une petite goupille emmanchée, contre lequel un des côtés de la partie excentrique 44 vient buter. En position libre, c'est-à-dire permettant de séparer la carte 32 de la bague, l'autre côté de la partie excentrique 44 vient buter contre le téton 50.

La figure 4 représente plus en détail un mode de réalisation d'un dispositif d'extraction selon la présente invention. L'axe 42 et la partie excentrique 44 sont formés d'une seule pièce et la molette 46 est fixée sur la partie inférieure de l'axe 42 par l'intermédiaire d'une goupille 52 traversant la molette et l'axe. La carte 32 est représentée en place dans l'évidement de la bague prévu pour la recevoir. Comme cela est représenté, la partie excentrique 44 est très plate et en forme de coin pour faciliter son insertion entre la carte 32 et le connecteur 36 et pour amorcer un début de décrochage de la carte 32.

De nombreuses variantes et modifications de la présente invention apparaîtront à l'homme de l'art. On peut par exemple envisager de munir les axes 42 d'une poulie et de relier ces poulies entre elles par l'intermédiaire d'un câble, ce qui permettrait une manipulation simultanée des dispositifs d'extraction.

D'autre part la présente invention a été décrite dans le cas particulier de l'embrochage d'une carte fille dans une carte mère de carte à pointes. Mais elle s'applique dans tous les cas où l'on a besoin de facilement retirer sans la tordre une carte embrochée.

## Revendications

1. Bague maintenant une carte fille circulaire (32) embrochée dans une carte mère (30) et comprenant :
- un filetage vertical intérieur se vissant sur un filetage extérieur solidaire de la carte mère (30) ; et
- un fond comportant un évidement cylindrique dans lequel est logée la carte fille (32), coaxial aux filetages et de profondeur sensiblement égale à l'épaisseur de la carte fille (32) ;
caractérisée en ce que la bague comprend dans son fond, autour de l'évidement, des axes verticaux traversants (42), comportant chacun à une extrémité, une partie excentrique (44), chaque axe pouvant être amené manuellement à une première position où sa partie excentrique obstrue partiellement l'évidement en maintenant la carte fille (32) sans la serrer dans l'évidement, ou à une deuxième position où sa partie excentrique ne maintient pas la carte fille dans l'évidement.

2. Bague selon la revendication 1, caractérisée en ce que chaque partie excentrique (44) est en forme de coin sensiblement parallèle au fond de la bague et à faible pente.

3. Bague selon la revendication 1, caractérisée en ce que le fond de la bague comprend des tétons (50) contre lesquels viennent buter les parties excentriques (44) à chacune des positions des axes (42).

4. Bague selon la revendication 1, caractérisée en ce que les autres extrémités des axes (42) sont munies de molettes (46).

5. Appareil de test d'une plaquette de puces de circuit intégré, comprenant :
- un dispositif de test (16) muni à sa partie supérieure d'une carte à pointes (22) qui palpent des plots d'une puce de la plaquette, la carte à pointes (22) comprenant des picots (27) montés sur ressort faisant saillie à la partie supérieure du dispositif (16) ; et
- une tête de test (12) disposée au-dessus du dispositif de test (16), et comprenant à sa partie inférieure une carte de test (28) venant contacter les picots montés sur ressort (27) ;
caractérisé en ce que la carte à pointes comprend une carte mère (30) dans laquelle est embrochée une carte fille (32) maintenue avec une bague (38) selon l'une quelconque des revendications 1 à 4.

## Patentansprüche

1. Ein Ring, der eine kreisförmige Tochterkarte (32) eingesteckt in eine Mutterkarte (mothercard) (30) enthält und folgendes aufweist:
ein vertikales Innengewinde aufschraubbar auf ein an der Mutterkarte (30) befestigtes Außengewinde;
einen Boden, der eine zylindrische Ausnehmung aufweist, in der die Tochterkarte (32) untergebracht ist, und zwar koaxial zu den Gewinden und mit einer Tiefe im wesentlichen gleich der Dicke der Tochterkarte (32);
dadurch **gekennzeichnet**, daß der Ring in seinem Boden um die Ausnehmung herum vertikal hindurchlaufende Stifte (42) aufweist, deren jeden an einem Ende einen Exzenterteil (44) aufweist, wobei jeder Stift manuell betätigbar ist, um in eine erste Position, wo sein Exzenterteil teilweise die Ausnehmung überdeckt, während die Tochterkarte (32) ohne Druck in der Ausnehmung gehalten wird, oder in eine zweite Position wo sein Exzenterteil die Tochterkarte nicht in der Ausnehmung hält gebracht zu werden.

2. Ring nach Anspruch 1, wobei jeder Exzenterteil (44) keilförmig ist und im wesentlichen parallel zum Boden des Rings verläuft und eine geringe Neigung aufweist.

3. Ring nach Anspruch 1, wobei der Boden des Rings Spitzen oder Anschläge (50) aufweist, gegen die die Exzenterteile (44) in jeder Position der Stifte (42) anschlagen.

4. Ring nach Anspruch 1, wobei die anderen Enden der Stifte (42) mit Rollen (46) versehen sind.

5. Vorrichtung zum Testen von Chips integrierter Schaltungen auf einem Wafer, wobei folgendes vorgesehen ist:
eine Testvorrichtung (16) versehen an der Oberseite mit einer Teststiftkarte (22), deren Teststifte die Anschlüsse (pads) eines Chips auf dem Wafer kontaktieren, wobei die Teststiftkarte (22) federgelagerte Stifte (27) aufweist, die an der Oberseite der Testvorrichtung vorstehen; und
ein Testkopf (12) angeordnet oberhalb der Testvorrichtung (16) und an seinem Boden eine Testkarte (28) aufweisend, die die federgelagerten Stifte (27) kontaktiert;
wobei die Teststiftkarte eine Mutterkarte (30) aufweist, in die eine Tochterkarte (32) eingesteckt ist, und zwar gehalten mittels eines Rings gemäß einem der Ansprüche 1 bis 4.

## Claims

1. A ring maintaining a circular daughtercard (32) plugged into a mothercard (30) and comprising:
- an inner vertical threading to be screwed on an external threading fixed to said mothercard (30);
- a bottom comprising a cylindrical recess wherein is accommodated said daughtercard (32), coaxial to the threadings and having a depth substantially equal to the thickness of said daughtercard (32);
characterized in that the ring comprises, in its bottom, about the recess, vertical traversing rods (42), each comprising at an end, an eccentric portion (44), each rod being manually operable to be brought to a first position where its eccentric portion partially covers the recess while maintaining said daughtercard (32) without pressure in the recess, or to a second position where its eccentric portion does not maintain said daughtercard in the recess.

2. A ring according to claim 1, wherein each eccentric portion (44) is wedge-shaped, is substantially parallel to the bottom of the ring and has a low slope.

3. A ring according to claim 1, wherein the bottom of said ring comprises keys (50) against which said eccentric portions (44) abut at each position of said rods (42).

4. A ring according to claim 1, wherein the other ends of said rods (42) are provided with rollers (46).

5. An apparatus for testing integrated circuit chips on a wafer, comprising:
- a prober (16) provided at its top with a probe-card (22), the probe-pins of which contact the pads of a chip on said wafer, said probe-card (22) comprising spring-mounted pegs (27) protruding at the top of said prober (16); and
- a test head (12) disposed above said prober (16), and comprising at its bottom a test card (28) contacting said spring-mounted pegs (27);
wherein the probe-card comprises a mothercard (30) in which is plugged a daughtercard (32) maintained by means of a ring (38) according to any of claims 1 to 4.
